# EUROPEAN PATENT SPECIFICATION

(11) **EP 0 833 959 B1**
(45) Date of publication and mention of the grant of the patent: **21.04.1999**
(21) Application number: 96920915.4
(22) Date of filing: 12.06.1996
(51) Int. Cl.: C23C 14/16

(54) **COATINGS FOR CORROSION PROTECTION**
KORROSIONSSCHUTZSCHICHTEN
REVETEMENTS DE PROTECTION CONTRE LA CORROSION

(30) Priority: 12.06.1995 GB 9511870
(43) Date of publication of application: 08.04.1998
(73) Proprietor: THE SECRETARY OF STATE FOR DEFENCE, Farnborough, Hampshire GU14 0LX (GB)
(72) Inventor: BALDWIN, Kevin, Richard, Defence Evaluation &, Hampshire GU14 6TD (GB); RAIKES, Deborah, Mary University of Manchester, P.O. Box 88 Manchester M60 1DQ (GB); LYON, Stuart Breinggan University of Manchester, P.O. Box 88 Manchester M60 1DQ (GB); NEWMAN, Roger Charles University of Manchester, P.O. Box 88 Manchester M601DQ (GB)
(74) Representative: Skelton, Stephen Richard
(86) International application number: GB9601402
(87) International publication number: WO9641898

(56) References cited:
- US-A- 4 758 479
- US-A- 4 872 932
- US-A- 5 002 837
- JOURNAL OF THE IRON AND STEEL INSTITUTE OF JAPAN, vol. 77, no. 7, July 1991, TOKYO JP, pages 137-144, XP000226098 J. KAWAFUKU ET AL: "STRUCTURE AND CORROSION RESITANCE OF ZINC ALLOY COATED STEEL SHEETS OBTAINED BY CONTINOUS VAPOR DEPOSITION APPARATUS."
- PATENT ABSTRACTS OF JAPAN vol. 016, no. 207 (C-0941), 18 May 1992 & JP,A,04 036476 (SUMITOMO METAL IND LTD), 6 February 1992,
- TRANSACTIONS OF THE JAPAN INSTITUTE OF METALS, SEPT. 1987, JAPAN, vol. 28, no. 9, ISSN 0021-4434, pages 692-698, XP000603086 YASUDA H ET AL: "Nonequilibrium crystalline and amorphous Zr-Zn alloys produced by vapor quenching"
- PATENT ABSTRACTS OF JAPAN vol. 18, no. 215 (C-1191), 18 April 1994 & JP,A,06 010116 (NIPPON STEEL CORP), 18 January 1994,
- CORROSION SCIENCE, 1991, UK, vol. 32, no. 5-6, ISSN 0010-938X, pages 621-633, XP000603206 BOHE A E ET AL: "An electrochemical impedance spectroscopy study of passive zinc and low alloyed zinc electrodes in alkaline and neutral aqueous solutions"
- VACUUM, FEB. 1995, UK, vol. 46, no. 2, ISSN 0042-207X, pages 203-210, XP000603188 MUSIL J ET AL: "Effect of ion bombardment on the surface morphology of Zn-films sputtered in an unbalanced magnetron"

## Description

The invention relates to coatings for corrosion protection, and more particularly relates to zinc-based coatings for the protection of steel substrates. The invention also relates to methods for the fabrication of such coatings.

Zinc-based protective coatings for steels are in widespread use, offering some barrier protection with the additional advantage that, being anodic to iron, zinc will also provide sacrificial protection at defects and discontinuities. Advances in electroplating technology since the mid-1970s have permitted the increasing use of electrodeposited alloys of zinc with another transition metal added to produce enhanced barrier properties in comparison with pure zinc coatings. Of particular importance in this regard are binary zinc-nickel alloys, although other alloys, for example zinc-cobalt and zinc-cobalt-iron, are also found to have a range of applications.

Zinc-based protective coatings can also be produced using vapour deposition techniques. An example of such a coating can be found in US-A-5 002 837 which discloses a zinc-magnesium alloy for use as a protective coating. This particular coating is crystalline in nature. Vapour deposition techniques can be used to produce an amorphous coating. Such a coating is disclosed in JP-A-06-010116 which describes the production of an amorphous zinc-titanium alloy coating by vapour plating. An alternative way to produce an amorphous layer is as a separate process after the substrate has been coated. Such a method is disclosed in JP-A-04-36476 which uses laser irradiation to melt the surface layer of a nickel-zinc alloy plated steel sheet then rapidly cools the sheet with liquid nitrogen to produce a thin surface amorphous layer.

These alloying additions, particularly nickel and cobalt, are elements which are cathodic to steel in practical environments. In these alloys it is found that with increasing alloying additions there is an initial rise in protectivity of the layer attributable to an increase in barrier corrosion resistance up to a certain optimum level, but a subsequent decline above the optimum level due to loss of sacrificiality. For example in the zinc-nickel system the optimum resistance is reached in practice at around 14-18 wt% Ni and these levels are most widely used (as described, for example, in "Corrosion Rate Measurements of Electrodeposited Zinc-Nickel Alloy Coatings", K.R. Baldwin et al, Corrosion Science, Vol 36, pp 1115-1131). In zinc-cobalt systems optimum levels are lower at around 4-8 wt% Co. Above these levels of alloying declining sacrificiality becomes a problem, and the problem is found to be exacerbated by a tendency for de-alloying as de-zincification occurs by preferential leaching of zinc into solution over extended periods of exposure to corrosive environments, resulting in gradual alloy ennoblement at the surface and eventual loss of sacrificiality.

A sacrificial coating offering enhanced corrosion resistance can be obtained by the use of cadmium. However, the toxicity of this material and attendant difficulties associated with the fabrication of the coatings tend to limit its applicability to protection of higher value substrates.

According to the present invention a corrosion resistant coating for a metallic substrate comprises a substantially amorphous layer of an alloy of zinc and between 1 and 50% by weight of alloying additions consisting essentially of at least one element selected from the group of transition metals nickel, cobalt, chromium, manganese, vanadium, iron and combinations thereof.

Suitable substrates are corrodible low-value bulk metal substrates relative to which zinc can offer sacrificial protection in a saline environment, and hence in particular steel substrates.

The invention comprises a coating which is characterised by a microstructure which is predominantly amorphous. Such a coating can be produced for example by using physical vapour deposition techniques. This contrasts with electrodeposited zinc-based alloy coatings in which, as is well established, a predominantly crystalline structure is found. Similar predominantly crystalline structures are also produced by the galvanizing and hot metal spraying techniques often used to apply unalloyed zinc layers. The amorphous coating is found to display passive-like corrosion behaviour in aqueous saline solutions, in that the dissolution of the coating is found to be strongly suppressed even at moderate anodic overpotentials. This behaviour is surprising in coatings at the high zinc levels of the present invention, since electrodeposited alloys will only show appreciable passivity in aqueous saline environments if the non-zinc alloying additions are present at very high levels, well in excess of 50% by weight.

The invention thus offers much improved corrosion barrier properties from a coating which remains zinc-rich. The problems arising from dezincification which occur in zinc-rich electrodeposited alloys during active corrosion attack are reduced by the passive behaviour of the amorphous layer. To achieve an equivalent passive behaviour in electrodeposited alloys would require much higher alloying element additions, with consequent increase in protective layer fabrication costs. Furthermore, in the commercially important systems based on alloys of zinc and one or more of iron, nickel and cobalt, comparable behaviour could only be achieved in electrodeposited layers by raising levels of alloying additions to such an extent that sacrificiality with respect to the steel in saline environments would be lost.

Appropriate alloying additions are selected from the group of transition metals exhibiting more noble electrochemical behaviour than zinc in a saline environment, and will therefore include nickel, cobalt, chromium, manganese, vanadium, iron and combinations thereof. Alloys of zinc with nickel, cobalt, iron, or combinations of these elements are particularly suitable. For practical purposes, and especially with a view to cost, lower levels of alloying additions are likely to be preferred. The alloy preferably comprises no more than 30% by weight of alloying additions, more preferably no more than 20% by weight of alloying additions. However, at the lowest levels of alloying addition there is a tendency for partly-crystalline coatings to be produced even by physical vapour deposition techniques.

Particularly preferred composition ranges of alloying additions are therefore found to be 4-18% by weight in binary zinc-nickel systems and 1-6% by weight in binary zinc-cobalt systems.

According to a further aspect of the present invention there is provided a method of applying a corrosion resistant coating to a substrate comprising the physical vapour deposition onto a substrate of a layer which has a predominantly amorphous character comprising a mixture of zinc and between 1 and 50% by weight of alloying additions consisting essentially of at least one element selected from the group nickel, cobalt, chromium, manganese, vanadium, iron and combinations thereof.

The application of the coating by physical vapour deposition produces an alloy microstructure which has a predominantly amorphous character, resulting in the enhanced corrosion barrier properties and in particular the passive-like behaviour described above.

Appropriate alloying additions are selected from the group of transition metals exhibiting more noble electrochemical behaviour than zinc in a saline environment, and will therefore include nickel, cobalt, chromium, manganese, vanadium, iron and combinations thereof, with alloys of zinc with nickel, cobalt, iron, or combinations of these elements being particularly preferred. For the reasons described above, coatings are preferably applied with composition ranges of alloying additions of 4-18% by weight in binary zinc-nickel systems and 1-6% by weight in binary zinc-cobalt systems.

In order to ensure concurrent deposition of the zinc vapour and the alloying element or elements in consistent relative quantities the physical vapour deposition is conveniently effected by unbalanced magnetron sputtering. This technique offers the advantage that elemental sources can be used instead of an alloy source, allowing accurate control of the composition of the deposited layer.

The invention will now be described by way of example only with reference to the accompanying figures in which:

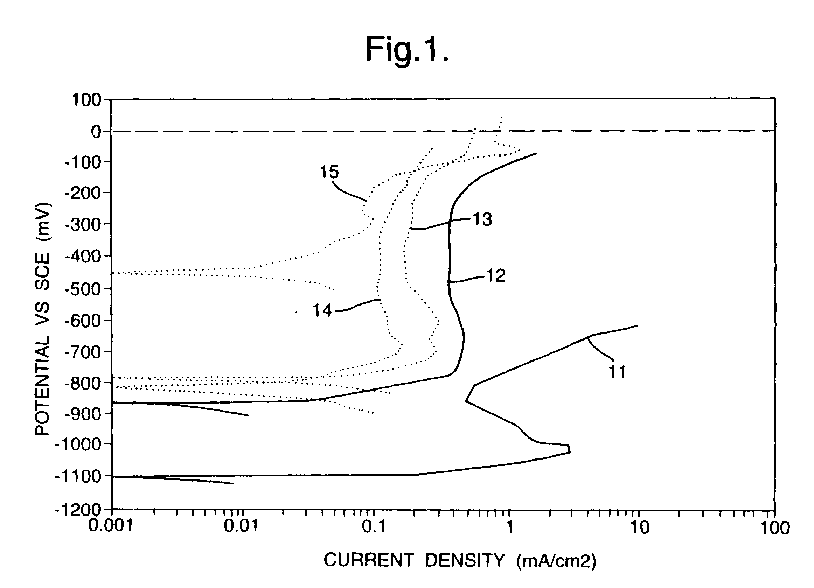

Figure 1 is a graphical representation of anodic polarisation sweeps of vapour deposited zinc-nickel alloys in accordance with the invention.

Examples of the invention were prepared by vapour depositing layers of binary zinc-nickel alloys onto a substrate to a thickness of the order of 10µm using an unbalanced magnetron sputtering technique with a pure zinc and a pure nickel source. Coatings were prepared having nickel contents in the range (by weight) of 1% to 18%. X-ray diffraction analysis of the layers showed that down to as low as 4% these alloys were deposited as an entirely amorphous layer, contrasting with the complex polycrystalline layers typically produced by the electrodeposition of alloys in this range. Below this level of nickel X-ray diffraction showed peaks indicating the presence of some crystalline ζ-phase (solid solution of nickel in zinc).

Figure 1 is illustrative of the electrochemical behaviour of sputtered binary zinc-nickel alloy coatings manufactured according to the invention. Anodic potentiodynamic polarisation sweeps of the zinc-nickel coatings were carried out after one hour total immersion in quiescent 500mmol 1⁻¹ NaCl solution at 25°C buffered to pH 4.75 at a sweep rate of 0.5 mV/s. Curves are shown for five alloy compositions with nickel contents in the commercially significant range of 1 to 18% nickel by weight, specifically with nickel contents of 1%, 11; 5.4%, 12; 11%, 13; 14%, 14; and 18%, 15, plotting potential versus SCE in mV against current density in mA/cm² on a logarithmic scale.

Figure 1 is valuable firstly as an illustration of the ennobled open circuit potential exhibited by coatings according to the invention, particularly for the amorphous layers laid down at nickel contents above around 4%. The 5.4% nickel layer, 12, 11% nickel layer, 13, and 14% nickel layer, 14, have an ennobled open circuit potential of about -850 to-800mV SCE. This compares with the well established prior art range for electrodeposited alloys of such compositions which is of the order of -1000 to -900mV (see, for example, "Corrosion Rate Measurements of Electrodeposited Zinc-Nickel Alloy Coatings", K.R. Baldwin et al, Corrosion Science, Vol 36, pp 1115-1131), whilst the open circuit potential of the 18% nickel alloy, 14, approaches that of pure nickel.

Figure 1 also illustrates that the sputtered alloys all show a degree of dissolution suppression even at moderate anodic overpotentials. This is the case even for the 1% nickel layer, 11, despite the partial crystallinity of the microstructure. The effect is even more marked for the other four amorphous layers, all of which exhibit apparently passive behaviour with very severely suppressed dissolution kinetics at 0.1-0.5mAcm⁻² in the apparently passive region. No such behaviour has been reported to have been observed for the prior art electrodeposited alloys.

## Claims

1. A corrosion resistant coating for a metallic substrate comprising a substantially amorphous layer of an alloy of zinc and between 1 and 50% by weight of alloying additions consisting essentially of at least one element selected from the group nickel, cobalt, chromium, manganese, vanadium, iron and combinations thereof.

2. A corrosion resistant coating according to claim 1 wherein the alloying additions are selected from the group nickel, cobalt, iron, and combinations thereof.

3. A corrosion resistant coating according to claim 2 comprising a substantially amorphous layer of a binary alloy of zinc and between 4 and 18% by weight of nickel.

4. A corrosion resistant coating according to claim 2 comprising a substantially amorphous layer of a binary alloy of zinc and between 1 and 6% by weight of cobalt.

5. A method of applying a corrosion resistant coating to a substrate comprising the physical vapour deposition onto a substrate of a layer which has a predominantly amorphous character comprising a mixture of zinc and between 1 and 50% by weight of alloying additions consisting essentially of at least one element selected from the group nickel, cobalt, chromium, manganese, vanadium, iron and combinations thereof.

6. A method according to claim 5 wherein the physical vapour deposition is effected by unbalanced magnetron sputtering.

7. A method according to claim 6 wherein the alloying additions are selected from the group nickel, cobalt, iron, and combinations thereof.

8. A method according to claim 7 wherein the layer comprises a mixture of zinc and between 4 and 18% by weight of nickel.

9. A method according to claim 7 wherein the layer comprises a mixture of zinc and between 1 and 6% by weight of cobalt.

## Patentansprüche

1. Korrosionsfeste Beschichtung für metallische Substrate, die eine im wesentlichen amorphe Schicht einer Legierung aus Zink und 1 bis 50 Gew.-% Legierungszusätzen aufweist, die im wesentlichen aus mindestens einem Element bestehen, das unter Nickel, Cobalt, Chrom, Mangan, Vanadium und Eisen sowie Kombinationen dieser Elemente ausgewählt ist.

2. Korrosionsfeste Beschichtung nach Anspruch 1, bei der die Legierungszusätze unter Nickel, Cobalt und Eisen sowie Kombinationen dieser Elemente ausgewählt sind.

3. Korrosionsfeste Beschichtung nach Anspruch 2, die eine im wesentlichen amorphe Schicht aus einer binären Legierung aus Zink und 4 bis 18 Gew.-% Nickel darstellt.

4. Korrosionsfeste Beschichtung nach Anspruch 2, die eine im wesentlichen amorphe Schicht einer binären Legierung aus Zink und 1 bis 6 Gew.-% Cobalt darstellt.

5. Verfahren zum Aufbringen einer korrosionsfesten Beschichtung auf ein Substrat, das die physikalische Dampfabscheidung einer Schicht auf ein Substrat umfaßt, die einen im wesentlichen amorphen Charakter aufweist und ein Gemisch aus Zink und 1 bis 50 Gew.-% Legierungszusätzen darstellt, die im wesentlichen aus mindestens einem Element bestehen, das unter Nickel, Cobalt, Chrom, Mangan, Vanandium und Eisen sowie Kombinationen dieser Elemente ausgewählt ist.

6. Verfahren nach Anspruch 5, bei dem die physikalische Dampfabscheidung durch Sputtern mit einem nichtkompensierten Magnetron vorgenommen wird.

7. Verfahren nach Anspruch 6, bei dem die Legierungszusätze unter Nickel, Cobalt und Eisen sowie Kombinationen dieser Elemente ausgewählt sind.

8. Verfahren nach Anspruch 7, bei dem die Schicht ein Gemisch aus Zink und 4 bis 18 Gew.-% Nickel darstellt.

9. Verfahren nach Anspruch 7, bei dem die Schicht ein Gemisch aus Zink und 1 bis 6 Gew.-% Cobalt darstellt.

## Revendications

1. Revêtement résistant à la corrosion pour un substrat métallique, comprenant une couche sensiblement amorphe d'un alliage de zinc et de proportions entre 1 et 50% en poids d'additions d'alliage consistant essentiellement en au moins un élément choisi dans le groupe nickel, cobalt, chrome, manganèse, vanadium, fer et des associations de ces éléments.

2. Revêtement résistant à la corrosion suivant la revendication 1, dans lequel les additions d'alliage sont choisies dans le groupe nickel, cobalt, fer et des associations de ces éléments.

3. Revêtement résistant à la corrosion suivant la revendication 2, comprenant une couche sensiblement amorphe d'un alliage binaire de zinc et d'une proportion comprise entre 4 et 18% en poids de nickel.

4. Revêtement résistant à la corrosion suivant la revendication 2, comprenant une couche sensiblement amorphe d'un alliage binaire de zinc et d'une proportion entre 1 et 6% en poids de cobalt.

5. Procédé d'application à un substrat d'un revêtement résistant à la corrosion, comprenant le dépôt en phase vapeur par des moyens physiques sur un substrat d'une couche qui est de caractère principalement amorphe et qui comprend un mélange de zinc et d'une proportion entre 1 et 50% en poids d'additions d'alliage consistant essentiellement en au moins un élément choisi dans le groupe nickel, cobalt, chrome, manganèse, vanadium, fer et des associations de ces éléments.

6. Procédé suivant la revendication 5, dans lequel le dépôt en phase vapeur par des moyens physiques est effectué par pulvérisation par magnétron non équilibré.

7. Procédé suivant la revendication 6, dans lequel les additions d'alliage sont choisies dans le groupe nickel, cobalt, fer et des associations de ces éléments.

8. Procédé suivant la revendication 7, dans lequel la couche comprend un mélange de zinc et d'une proportion entre 4 et 18% en poids de nickel.

9. Procédé suivant la revendication 7, dans lequel la couche comprend un mélange de zinc et d'une proportion entre 1 et 6% en poids de cobalt.
